# EUROPEAN PATENT SPECIFICATION

(11) **EP 1 612 939 B1**
(45) Date of publication and mention of the grant of the patent: **11.08.2010**
(21) Application number: 05300484.2
(22) Date of filing: 16.06.2005
(51) Int. Cl.: H03K 17/615, H02M 3/156

(54) **Switching DC-DC converter**
Geschalteter Gleichstromwandler
Convertisseur courant continu-courant continu à commutation

(30) Priority: 30.06.2004 EP 04015302
(43) Date of publication of application: 04.01.2006
(73) Proprietor: Thomson Licensing, 92130 Issy-les-Moulineaux (FR)
(72) Inventor: Kögel, Reinhard, 78086, Brigachtal (DE); Louvel, Jean-Paul, 78086, Brigachtal (DE)
(74) Representative: Arnold, Klaus-Peter

(56) References cited:
- DE-A- 3 420 583
- US-A- 4 430 608
- US-A- 5 731 731
- US-B1- 6 452 366
- April 2004 (2004-04), XP002309277 Retrieved from the Internet: URL:http://www.onsemi.com/pub/Collateral/M C34063A-D.PDF> [retrieved on 2004-12-07]

## Description

### FIELD OF THE INVENTION

The present invention relates to a switching DC-DC converter comprising an integrated control circuit for the generation of a stabilized DC output voltage. The DC-DC converter comprises in particular an inductor and a diode for operating as a step-down converter, a step-up converter or a voltage inverting converter.

### BACKGROUND

For generating a stabilized DC output voltage, more and more switching regulators are used for the DC-DC conversion, because of the high efficiency of the switched mode power supplies. New equipment designs and low parts costs with a simple design make the use of switching regulators more pronounced over that of linear regulators. A further advantage of the switching regulator is the increased application flexibility of the output voltage, which can be less than, greater than, or of opposite polarity to that of the input voltage.

When using a monolithic integrated control circuit, only a few circuit parts are required for designing a DC-DC converter. Control circuits of this kind comprise in particular an internal temperature compensated reference voltage, a comparator, a controlled duty cycle oscillator with an active current limit circuit, a driver stage and a high current output switch. A known monolithic control circuit of this kind is for example the integrated circuit MC34063 manufactured by ON Semiconductor Components Industries.

A DC-DC converter of this kind, operating as a down-converter, is shown in figure 1. The DC-DC converter comprises an inductor L1, a diode D1 and an integrated control circuit IC1, for providing a stabilized DC output voltage U2. The inductor L1 is in particular a coil. The control circuit IC1 is in this application the integrated circuit MC34063A.

The control circuit IC1 comprises a reference voltage generator RG and a comparator CO for the regulation of the output voltage U2. It comprises further an oscillator OS, having an input terminal 3, to which a capacitor C3 is coupled for defining the oscillation frequency of the oscillator OS. The control circuit IC1 comprises further a logic circuit LC and an output stage with a driver transistor Q2 and an output switch Q1, the transistor Q2 driving the output switch Q1. The comparator CO and the oscillator OS are coupled to the logic circuit LC for operating the output stage.

The control circuit IC1 operates with an input voltage U0, coupled to current inputs 1, 6, 7 and 8 of the control circuit IC1. An overload protection is provided for the DC-DC converter via a low resistance resistor R1 coupled to terminals 6 and 7 of the control circuit IC1. The output switch Q1 is coupled with a current input, terminal 1, to the input voltage U0 and with a current output, terminal 2, to a first terminal of the coil L1 for providing a voltage U1 for the operation of the coil L1.

A freewheeling diode D1 is coupled between ground and terminal 2. The coil L1 is coupled with a second terminal to an output capacitor C2, which provides a smoothing of the output voltage U2. The voltage U2 is coupled via a voltage divider, resistors R3 and R2, and terminal 5 to the comparator CO of the control circuit IC1, for providing a feedback loop FB for the regulation of the DC-DC converter.

The circuit as described above is known and similar circuits are suggested in application sheets of IC manufacturers. Detailed application data for the MC34063 are available by ON Semiconductor Components under HTTP://onsemi.com in a data sheet, Rev. 15, April 2004, Publication Order Number MC34063A/D. According to the data sheet, the maximum permissible switch current for the MC34063 is 1,5 A.

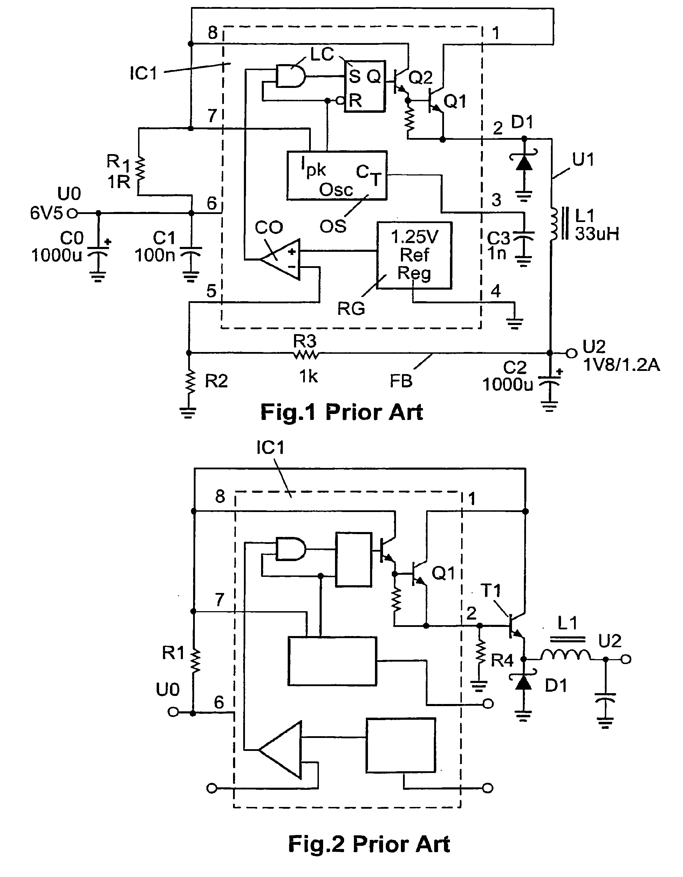

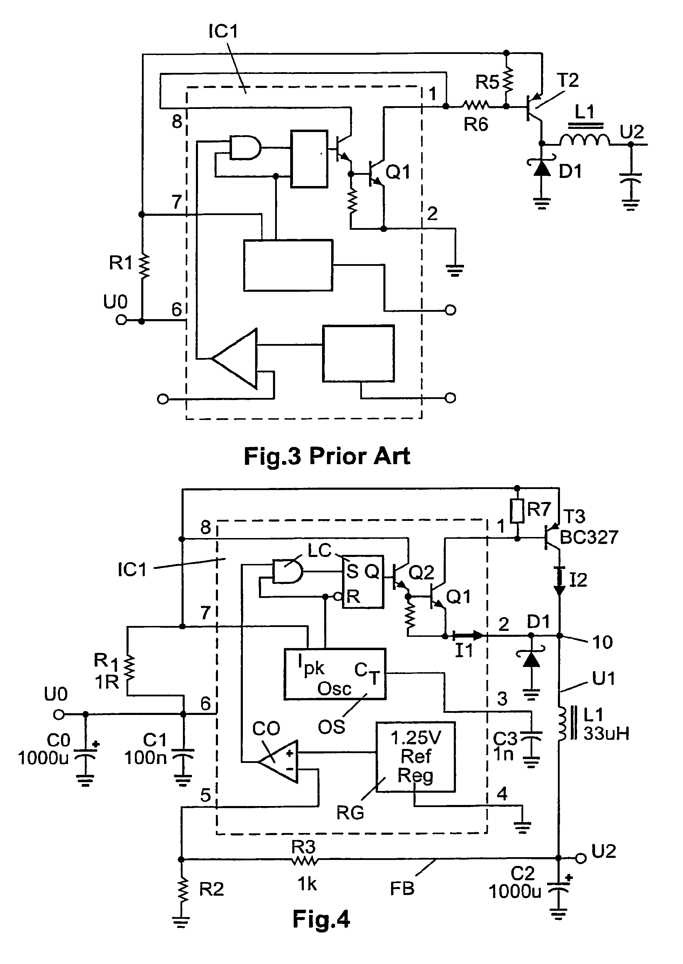

For peak currents higher than 1,5 A, the DC-DC converter has to include an external power transistor, as shown in figures 2 and 3. In figure 2 a npn-transistor T1 is coupled with a current input to the input voltage U0 and to the terminal 1 of the integrated circuit IC1. The base terminal of the transistor T1 is coupled to the terminal 2 of the integrated circuit IC1 and the current output is coupled to the inductor L1. The output switch Q1 operates therefore as a driver stage for the transistor T1. The regulation loop of the DC-DC converter, not shown, corresponds to the regulation loop of figure 1.

A resistor R4 couples the base terminal of transistor T1 to ground. When the output switch Q1 is blocked, the transistor T1 is blocked also. When Q1 switches through, the transistor T1 switches through respectively, the output switch Q1 providing therefore only the base current for the transistor T1. The current through the transistor T1 is therefore correspondingly higher depending on the current amplification factor of the transistor T1. Therefore, all the current for operating the inductor L1 is provided by the current output of the transistor T1, and hence a power transistor has to be used in accordance with the required output power.

In figure 3 a DC-DC converter of the above mentioned datasheet is shown, in accordance with the preamble of the claim 1, which uses a pnp-transistor T2 for providing a higher output power. The current input of the transistor T1 is the emitter, which is coupled in this embodiment to the input voltage U0. The current output, the collector, is coupled to the inductor L1. A resistor R5 couples the base terminal of transistor T2 to the input voltage U0 and a resistor R6 to the terminal 1 of the integrated circuit IC1. The terminal 2 of the integrated circuit IC1 is coupled to ground.

The operation of the DC-DC converter shown in figure 3 is similar to the operation of the DC-DC converter of the figure 2: When the output switch Q1 of the integrated circuit IC1 switches through, a current flows through the emitter and base of transistor 2 through switch Q1, switching through therefore transistor T2. When Q1 is blocked, the transistor T2 is blocked also, because then the voltage present at the base of transistor Q2 is high.

Corresponding applications for step-up converters and voltage inverting converters are also described in the data sheet for the integrated circuit MC34063.

DE-A-3420583 discloses a switching DC-DC converter comprising two pnp-transistors T1, T2, which are arranged in a Darlington figuration, in which the transistor T2 works as a driver for providing the base current for transistor T1. US 4430608 describes DC-DC converters with Darlington transistor arrangements having two pnp-transistors, and with complementary Darlington arrangements having two npn-transistors.

US 6452366 described a switching DC-DC converter having two systems using each a FET transistor in parallel, which system are both used in high power mode, and one system being disabled in a low power mode for reducing switching losses.

### SUMMARY OF THE INVENTION

It is the object of the present invention, to provide a low-cost DC-DC converter as described above having an extended power range, reducing in particular the heat stress for the integrated control circuit in a medium power range.

This object is achieved with a switching DC-DC converter as specified in the claim 1. Advantageous embodiments of the invention are specified in the subclaims.

The switching DC-DC converter according to the invention comprises an inductor, a and an integrated control circuit with an output switch for generating an output voltage. The output switch and the diode are coupled to the inductor for operating for example as a step-down converter, a step-up converter or a voltage inverting converter. A transistor is coupled with a control input to a current input of the output switch, with a current input to an input voltage of the DC-DC converter, and with a current output to a current output of the output switch.

The transistor is coupled in parallel therefore with the output switch of the control circuit for providing an additional current for the operation of the inductor. The inductor is therefore operated with the sum of two currents, one provided by the transistor and the second by the output switch of the integrated control circuit.

The ratio between the two currents is adjusted advantageously via an impedance, which is coupled between the current input and the control input of the transistor, for providing a current to the current input of the output switch of the integrated control circuit and for providing a control current for the transistor. The value of the impedance is chosen such that in a low power range the voltage across the impedance is not sufficient for opening the transistor. The current for the operation of the inductor is then provided totally by the output switch.

Only in a power range above or slightly below the specification of the integrated control circuit, the voltage drop across the impedance is sufficient to open the transistor, therefore extending the output power range of the DC-DC converter to a power above the specified current of the integrated control circuit. In particular, in a medium power range a low power transistor type can be used, which is much cheaper than a power transistor. Advantageously, the transistor may start conducting also already in a power range, in which the current through the output switch is below the specified maximum current, for reducing the heat stress of the integrated control circuit.

### BRIEF DESCRIPTION OF THE DRAWINGS

Preferred embodiments of the invention are explained in more detail with regard to a schematic drawing. The drawings show:
- Figure 1: a prior art switching DC-DC converter with an integrated control circuit, the converter operating as a step-down converter,
- Figure 2: a prior art step-down converter, comprising an external npn-transistor for providing a higher output current,
- Figure 3: a prior art step-down converter comprising an external pnp-transistor, and
- Figure 4: a step-down converter with an external transistor in accordance with the invention.

In figure 4 a switching DC-DC converter is shown comprising an integrated control circuit IC1, to which an input voltage U0 is coupled, supply voltage inputs 1, 6, and 8. The control circuit IC1 is for example a low cost integrated circuit MC34063A. The DC-DC converter comprises further a diode D1, an inductor L1, in this embodiment a coil, and a feedback loop FB, which are arranged for operating as a step-down converter. The DC-DC converter provides an output voltage U2, which is stabilized via the feedback loop FB. The circuit as described so far corresponds to the DC-DC converter as shown in figure 1.

According to the invention, a transistor T3 is coupled in parallel with the output switch Q1 of the control circuit IC1 for providing an additional current 12 for the operation of the inductor L1. The control circuit IC1 comprises an output switch Q1, which provides a current I1 for the operation of the inductor L1. The current 12 from the transistor T3 is adjusted via an impedance R7, in this embodiment a resistor, which is coupled between the current input and the control input of the transistor T3. The currents I1 and 12 are summed up in a node 10, ahead of the inductor L1.

The operation of the DC-DC converter is as follows: When the output switch Q1 is switched through by the transistor Q2, a current flows through the impedance R7 and the output switch Q1, leading to the current I1. The resistor R7 has a resistance value of 0,75 Ohm, which leads for a current below 1 Ampere to a voltage drop of below 0,75 Volts. Therefore, for a current I1 below 1 Ampere, the transistor T3 is more or less closed. For a current above 1 Ampere, the voltage drop across resistor R7 is above 0,75 Volts, when the output switch Q1 is switched through, which leads to a switching through of the transistor T3. Therefore, for a current above about 1 Ampere, an additional current 12 is provided for the operation of the inductor L1.

Hence, the heat dissipation of the integrated circuit IC1 is reduced for a higher power range corresponding to a current of above 1 Ampere, when using a transistor T3 in parallel to the output switch Q1. Further, for a power range corresponding to a current of about 1,5 Ampere, the main part of the output current is provided by the control circuit IC1. Therefore, in this range the heat dissipation of the transistor T3 is still low, which allows using a low-cost transistor, for example the type BC327. This transistor is specified for a maximum peak current of 1 A and a maximum power dissipation of 0,6 W.

For a further extension of the output power, several low cost pnp-transistors may be coupled in parallel with the transistor T3, which are still cheaper than a single power transistor. In this application, the additional transistors are each coupled with the current input to the input voltage U0, with the control input to the terminal 1 and with the current output to the terminal 2 of the integrated circuit IC1.

The DC-DC converter as shown in figure 4 therefore has the advantage, that a smaller external transistor can be used as compared with the circuits of figures 2 and 3, which leads to a DC-DC converter with reduced costs.

The present invention is not limited to the embodiments as described with regard to the figure 4, and various available modifications come possible for those skilled in the art without departing from the scope of the invention. In particular, any other transistor may be used for the transistor T3, for example also a field effect transistor, or any other controllable switching element. The invention is also applicable to step-up converters and voltage inverting converters.

## Claims

1. Switching DC-DC converter comprising
an inductor (L1),
a diode (D1),
a pnp-transistor (T3)
an integrated control circuit (IC1) comprising an input (6, 8, 1), to which a DC input voltage (U0) is applied, and comprising an output switch (Q1)being an npn-transistor, the output switch (Q1) and the diode (D1) being coupled to a first terminal of the inductor (L1) for providing a DC output voltage (U2),and
an impedance (R7) coupled between an input voltage (U0) and the control input of the pnp-transistor (T3)
for refining the current through the pnp-transistor (T3), **characterised in that**
a current input and a current output of the pnp-transistor (T3) are coupled in parallel to a current input (1) and current output (2) of the output switch (Q1) for providing an additional current for the operation of the inductor (L1), wherein the resistance value of the impedance (R7) is selected such, that the pnp-transistor (T3) is blocking, when the current of the output switch (Q1) is within the specification of the control circuit (IC1), and wherein the pnp-transistor (T3) is conducting for providing a current to the inductor (L1) in a higher power range, which is above the specification of the control circuit (IC1).

2. Switching DC-DC converter in accordance with claim 1, wherein the pnp-transistor (T3) is of a low power type with a maximum peak current of 1 Ampere.

3. Switching DC-DC converter in accordance with claim 1 or 2, wherein the control circuit (IC1) is an integrated monolithic control circuit comprising an internal reference voltage generator (RG), a comparator (CO), a controlled duty cycle oscillator (OS), a logic circuit (LG) coupled to the output switch (Q1), and an input of the comparator (CO) being coupled with a reference voltage of the reference voltage generator (RG).

4. Switching DC-DC converter in accordance with one of the preceding claims, wherein the inductor (L1), the diode (D1) and the integrated control circuit (IC1) are arranged for operating as a step-down converter, a step-up converter or a voltage inverting converter.

5. Switching DC-DC converter in accordance with claim 4, wherein the DC-DC converter comprises further a feedback loop (FB) for a stabilized DC output voltage (U2).

6. Switching DC-DC converter in accordance with claim 5, wherein, a second terminal of the inductor (L1) is coupled to an output capacitor (C2) for providing a DC output voltage (U2), the DC output voltage (U2) is coupled to a control input (5) of the control circuit (IC1) via the feedback loop (FB) for stabilizing the DC output voltage (U2), and the diode (D1) is coupled between ground and the first terminal of the inductor (L1) for the operation as a step-down converter.

## Patentansprüche

1. Schaltgleichstromwandler, der umfasst:
eine Induktionsspule (L1),
eine Diode (D1),
einen pnp-Transistor (T3),
eine integrierte Steuerschaltung (IC1), die einen Eingang (6, 8, 1) umfasst, an den eine Eingangs-Gleichspannung (U0) angelegt wird, und die einen Ausgangsschalter (Q1) umfasst, der ein npn-Transistor ist, wobei der Ausqangsschalter (Q1) und die Diode (D1) mit einem ersten Anschluss der Induktionsspule (L1) gekoppelt sind, um eine Ausgangsgleichspannung (U2) bereitzustellen, und
eine Impedanz (R7), die zwischen eine Eingangsspannung (U0) und einen Steuereingang des pnp-Transistors (T3) geschaltet ist, um den Strom durch den pnp-Transistor (T3) zu definieren, **dadurch gekennzeichnet, dass** ein Stromeingang und ein Stromausgang des pnp-Transistors (T3) zu einem Stromeingang (1) und zu einem Stromausgang (2) des Ausgangsschalters (Q1) parallelgeschaltet sind, um einen zusätzlichen Strom für den Betrieb der Induktionsspule (L1) bereitzustellen, wobei der widerstandswert der Impedanz (R7) in der Weise gewählt ist, dass der pnp-Transistor (T3) sperrt, wenn der Strom des Ausgangsschalters (Q1) innerhalb der Spezifikation der Steuerschaltung (IC1) liegt, und wobei der pnp-Transistor (T3) leitet, um für die Induktionsspule (L1) einen Strom in einem höheren Leistungsbereich bereitzustellen, der über der Spezifikation der Steuerschaltung (IC1) liegt.

2. Schaltgleichstromwandler nach Anspruch 1, bei dem der pnp-Transistor (T3) ein Niederleistungstyp mit einem maximalen Spitzenstrom von 1 Ampere ist.

3. Schaltgleichstromwandler nach Anspruch 1 oder 2, bei dem die Steuerschaltung (IC1) eine monolithische integrierte Steuerschaltung ist, die einen internen Referenzspannungsgenerator (RG), einen Komparator (CO), einen Oszillator (OS) mit gesteuertem Tastgrad, eine Logikschaltung (LG), die mit dem Ausgangsschalter (Q1) gekoppelt ist, umfasst und ein Eingang des Komparators (CO) mit einer Referenzspannung des Referenzspannungsgenerators (RG) gekoppelt ist.

4. Schaltgleichstromwandler nach einem der vorhergehenden Ansprüche, bei dem die Induktionsspule (L1), die Diode (D1) und die integrierte Steuerschaltung (IC1) für den Betrieb als ein Abwärtswandler, als ein Aufwärtswandler oder als ein Spannungsinvertierungswandler angeordnet sind.

5. Schaltgleichstromwandler nach Anspruch 4, bei dem der Gleichstromwandler ferner eine Rückkopplungsschleife (FB) zum Erzeugen einer stabilisierten Ausgangsgleichspannung (U2) umfasst.

6. Schaltgleichstromwandler nach Anspruch 5, bei dem ein zweiter Anschluss der Induktionsspule (L1) mit einem Ausgangskondensator (C2) gekoppelt ist, um eine Ausgangsgleichspannung (U2) bereitzustellen, wobei die Ausgangsgleichspannung (U2) über die Rückkopplungsschleife (FB) mit einem Steuereingang (5) der Steuerschaltung (IC1) gekoppelt ist, um die Ausgangsgleichspannung (U2) zu stabilisieren, und die Diode (D1) für den Betrieb als ein Abwärtswandler zwischen die Masse und den ersten Anschluss der Induktionsspule (L1) geschaltet ist.

## Revendications

1. Convertisseur continu-continu de commutation comprenant une bobine d'induction (L1),
une diode (D1),
un transistor PNP (T3),
un circuit de commande intégré (IC1) comprenant une entrée (6, 8, 1), à laquelle une tension d'entrée CC (U0) est appliquée, et comprenant un commutateur de sortie (Q1) étant un transistor NPN, le commutateur de sortie (Q1) et la diode (D1) étant couplés à une première borne de la bobine d'induction (L1) pour fournir une tension de sortie CC (U2), et
une impédance (R7) couplée entre une tension d'entrée (U0) et l'entrée de commande du transistor PNP (T3) pour définir le courant via le transistor PNP (T3), **caractérisé en ce que**
une entrée de courant et une sortie de courant du transistor PNP (T3) sont couplées en parallèle à une entrée de courant (1) et une sortie de courant (2) du commutateur de sortie (Q1) pour fournir un courant additionnel pour le fonctionnement de la bobine d'induction (L1), où la valeur de résistance de l'impédance (R7) est sélectionnée de telle manière que le transistor PNP (T3) se bloque, lorsque le courant du commutateur de sortie (Q1) respecte la spécification du circuit de commande (IC1), et où le transistor PNP (T3) est conducteur afin de fournir un courant à la bobine d'induction (L1) selon une plage de puissance plus élevée, laquelle est supérieure à la spécification du circuit de commande (IC1),

2. Convertisseur continu-continu de commutation selon la revendication 1, où le transistor PNP (T3) est d'un type de puissance faible avec un courant de crête maximal d'1 ampère.

3. Convertisseur continu-continu de commutation selon la revendication 1 ou 2, où le circuit de commande (IC1) est un circuit de commande monolithique intégré comprenant un générateur de tension de référence interne (RG), un comparateur (CO), un oscillateur (OS) de cycle de service commandé, un circuit logique (LG) couplé au commutateur de sortie (Q1), et une entrée du comparateur (CO) étant couplée avec une tension de référence du générateur de tension de référence (RG).

4. Convertisseur continu-continu de commutation selon une des revendications précédentes, où la bobine d'induction (L1), la diode (D1) et le circuit de commande intégré (IC1) sont agencés pour fonctionner en tant que convertisseur abaisseur, convertisseur élévateur ou convertisseur d'inversion de tension.

5. Convertisseur continu-continu de commutation selon la revendication 4, où le convertisseur continu-continu comprend en outre une boucle de rétroaction (FB) pour générer une tension de sortie CC stabilisée (U2).

6. Convertisseur continu-continu de commutation selon la revendication 5, où une deuxième borne de la bobine d'induction (L1) est couplée à un condensateur de sortie (C2) pour fournir une tension de sortie CC (U2), la tension de sortie CC (U2) est couplée à une entrée de commande (5) du circuit de commande (IC1) via la boucle de rétroaction (FB) pour stabiliser la tension de sortie CC (U2), et la diode (D1) est couplée entre la terre et la première borne de la bobine d'induction (L1) pour le fonctionnement en tant que convertisseur abaisseur.
